# EUROPEAN PATENT APPLICATION

(11) **EP 1 130 130 A1**
(43) Date of publication of application: **05.09.2001**
(21) Application number: 00830153.3
(22) Date of filing: 29.02.2000
(51) Int. Cl.: C23C 16/44, H01L 21/316

(54) **Method and reactor for SACVD deposition**

(71) Applicant: STMicroelectronics S.r.l., 20041 Agrate Brianza (Milano) (IT)
(72) Inventor: Vulpio, Michele, 70050 Santo Spirito (BA) (IT)
(74) Representative: Botti, Mario

(57) **Abstract**

The invention relates to a method and to a related reactor for applying a SACVD deposition technique in the fabrication of semiconductor integrated circuits. The method comprises at least one step of depositing a layer of dielectric material, carried out inside a deposition reactor (1) which is fed by a stream of reaction gas. Advantageously, a remote plasma of reaction oxygen (O₂) is employed which is subjected to microwave within the gas feed conduit (3) to the reactor (1), in order to generate sufficient free radicals of the gas, sufficient to initiate the deposition reaction.

## Description

### Field of the Invention

This invention relates to an SACVD (Sub-Atmospheric Chemical Vapor Deposition) application method for fabricating semiconductor integrated circuits.

The invention also relates to a deposition reactor implementing the above method.

The invention broadly concerns a method for fabricating monolithically integrated electronic circuits having at least one dielectric material layer. The following description will cover deposition aspects of overlapping dielectric layers for convenience of illustration only.

Providing adjacent or overlapping dielectric material layers, having the same composition, is fairly common in today's electronic technologies, and at various stages of manufacturing integrated circuits. In order to form two-stack layers of this kind, it is standard practice to have a first layer of dielectric material partly or fully overlapped by a second dielectric layer.

However, before forming the second layer, there can be intermediate process phases leading to the formation of a sacrificial layer which is then in part or fully removed.

At all events, at the end of these process phases, the second dielectric layer will have its bottom surface directly in contact with the top surface of the first dielectric layer.

Dielectric materials, such as silicon oxide or nitride, are usually used either to provide electrical isolation between conductive layers or to protect underlying integrated circuit structures from contamination. A basic aim of two-stack dielectric layers is to ensure protection also in the event of one of the layers becoming damaged. Therefore, it is important that in any of the portions of the two-stack layer is left a doubtful adhesion between the overlapping layers.

Nevertheless, some materials have adhesion problems at the interface. These problems may originate from inherent characteristics of the material not yet fully understood by the experts. For example, it is believed that, because of the different thickness of the layers, stress situations which tend to delaminate the material can occur, when such strain exceed the molecular attraction force between the layers.

Contributing factors may be the total of the processing steps undergone by the semiconductor, or different processing temperatures.

In addition, proper adhesion between the overlapping layers is made difficult to achieve because of certain processing methods customarily applied during the fabrication of integrated circuits.

### Prior Art

As the skilled ones in the art know well, the dielectric layers, except for the first one which can be formed by thermal oxidation, are usually formed by deposition techniques such as CVD (Chemical Vapor Deposition) performed inside a reactor. The chemical precursor of the element to be deposited is reacted during the gas phase.

The chemio-physical properties of the layer are controlled by such processing parameters as pressure and the concentration of reactive gases like O₃ and TEOS (TetraEthylOrthoSilicate).

However, the dielectric formed with the CVD method is often uneven through its thickness due to a sort of reactive inertia at the initial phase of the deposition.

Furthermore, any residues left of previous processing phases on the surface of the first layer may interfere with the deposition and proper adhesion between the layers, especially when the dielectric materials happen to be markedly stiff, as is the case of silicon nitride and oxynitride.

Aimed at improving the adhesion between dielectric material layers, certain techniques have been developed wherein the surface of the underlying layer is treated previously to forming the second layer.

For example, a sputtering process phase of ion bombarding the surface of the first layer may be carried out to enhance adhesion of the reactants to be deposited. This is done, for example, with layers of silicon oxide deposited using TEOS as precursor.

Another viable approach is represented by a prior art as SACVD (Sub-Atmospheric Chemical Vapor Deposition), which consists of depositing a doped or undoped film of silicon oxide based on the combustive reaction of O₂ and TEOS initiated by the presence of ozone (O₃).

Details of this technique can be found in Journal of the Electrochemical Society, Vol. 138, No. 10, October 1991, Manchester, New Hampshire, US, pages 3019-3024, K. Fujino et al.,"Doped Silicon Oxide Deposition by Atmospheric Pressure and Low Temperature Chemical Vapor Deposition Using Tetraethoxysilane and Ozone".

The peculiar feature of this deposition technique is a good gap-fill and excellent step coverage, which can be achieved by optimizing the deposition parameters. It has, however, a major limitation in its low throughput of no more than 6.5 wafers/hour.

The use of ozone (O₃) has several drawbacks:
- it is a highly harmful gas;
- the proportion of ozone is dictated by the limitations of the ozonizer power output;
- the TEOS flow cannot be increased, for getting a higher throughput, without at the same time loose gap-fill.

At process temperature, ozone undergoes almost complete dissociation already inside the reactive gas injection system (shawer head), into O₂ and O radicals which constitute radical initiators activating the combustion process.

It is known, from literature as well as from tests carried out by the Applicant, that the gap filling rate of the dielectric film improves with increased pressure and ozone proportion, and decreased TEOS flow rate. Unfortunately, equipment throughput proceeds in the reverse direction. Accordingly, raising the flow rate of TEOS while keeping the ozone ratio unaltered, for maximum gap filling performance, appears to be the most convenient course to get a higher process capacity.

However, this ideal setting has a limitation in the ability to maximize the ozone percentage with the ozonizers currently in use. These ozonizers can supply 17% ozone at most.

The underlying technical problem of this invention is to provide a method of applying the deposition SACVD technique which can improve the yield in the deposition of dielectric layers, with good step coverage, thereby overcoming the limitations of the aforementioned solutions with reference to the prior art.

### Summary of the Invention

The principle of this invention is to use a remote oxygen (O₂) plasma to generate the oxygen radicals necessary for initiating the combustion process and without using ozone. The oxygen radicals are directly produced by a magnetron associated with the deposition reactor and capable of providing maximum scattering of the molecules introduced into the reaction chamber.

Based on this principle, the technical problem is solved by a method as previously indicated and defined by the characterizing part of Claim 1.

The technical problem is further solved by a deposition reactor as defined in Claim 6.

The features and advantags of the method and of the reactor according to the invention can be more clearly understood by reading the following description of embodiments thereof, given by way of non-limitative examples with reference to the accompanying drawings.

In the drawings:

### Brief Description of the Drawings

Figure 1 schematically shows a process reactor wherein a deposition SACVD process is carried out according to the prior art; and
Figure 2 schematically shows a modification made unto the process reactor in order to carry out a deposition SACVD process with the method of this invention.

### Detailed Description

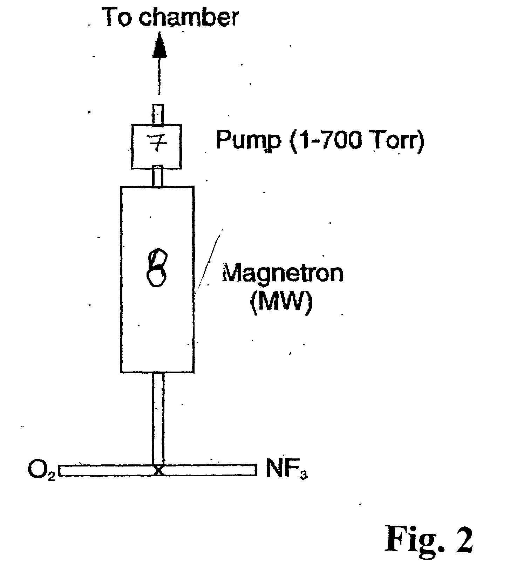

Referring to Figure 2, a process reactor for fabricating electronic circuits integrated on a semiconductor, in which deposition SACVD operations are carried out according to the method of this invention, is generally and schematically shown at 1.

The reactor 1 is constructed similar to conventional reactors, but has been modified allowing the method of this invention to be implemented. This reactor has a reaction chamber 2, basically comprising a quartz tube, which chamber receives or is injected by components of the reaction which leads to the formation of deposited layers of dielectric material on the semiconductor.

The reaction chamber 2 is provided conventionally with an opening for introducing the semiconductor wafers to be reacted, and subsequently taking them out.

A gas feed conduit 3 leads to the interior of the reaction chamber 2 for feeding the chamber interior with gas phase reactants. This feed conduit 3 branches off outside the chamber 2 to receive separate gas streams from respective sources, not shown.

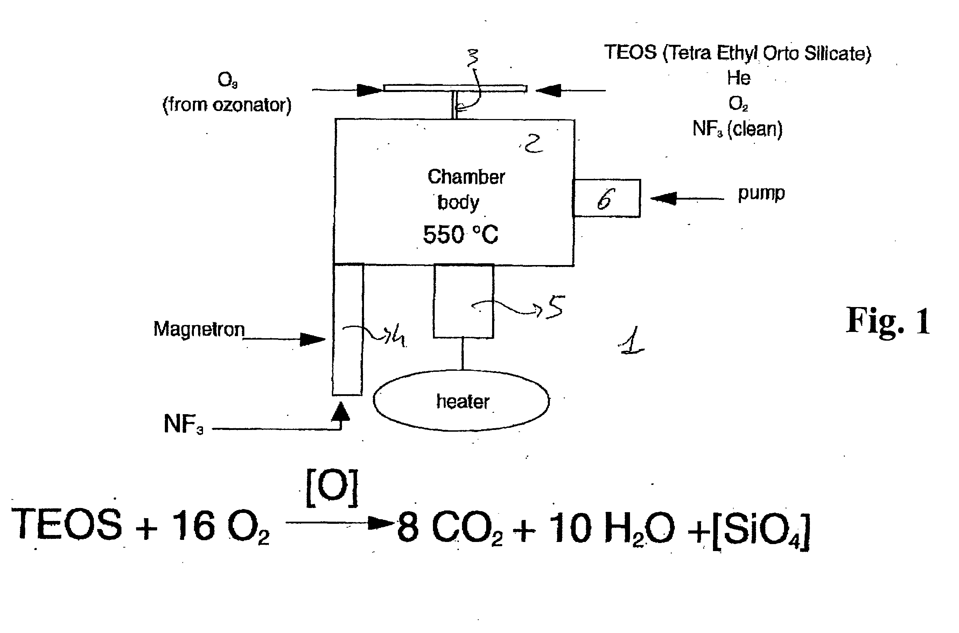

In the prior art, the reaction chamber 2 has a magnetron device 4 associated therewith which emits electromagnetic waves into the chamber for the purpose of scattering the gas molecules therein, in accordance with the method of this invention. In the standard design of Figure 1, the magnetron is only to dissociate the NF₃ gas for cleaning.

The reaction chamber 2 also includes a heater 5 for raising its internal temperature to a predetermined fixed value for the chemical reaction to take place.

Advantageously in this invention, a pump 6 for adjusting the process pressure is associated with the reaction chamber 2. Advantageously in this invention, an additional pump 7 is provided on the process gas feed conduit 3, for a purpose to be explained. The pump 7 may be a rotor pump.

Also, a magnetron 8 is mounted on the conduit 3 upstream of the pump 7.

The method of this invention will now be described in detail.

During the SACVD process which leads, by deposition, to the formation of layers of dielectric material on semiconductor, a stream of oxygen (O₂) plasma, generated within the magnetron, is fed into the reaction chamber 2 through the feed conduit 3.

The magnetron device is operated to scatter the oxygen molecules as much as possible, thereby enabling free oxygen (O) radicals to be released onto the substrate, without exposing it to the plasma action.

In this way, i.e. by adjusting the magnetron action, a proportion of oxygen (O) radicals can be produced in a wide range of concentrations (ideally 0 to 98%).

This is specially important to an optimum gap filling of the dielectric material layer being formed, even at others than the standard TEOS flow rate.

This allows the throughput of the reactor 1 to be increased with no tradeoffs for the properties of this SACVD deposition technique.

An essential feature of the method according to this invention is that ozone (O₃) is not used as a process gas.

The difference between current reactors and the reactor 1 of the invention is basically that the magnetron 4 is provided additionally with an oxygen line. Further, the impedance adapter (matching network) connected thereto is to suit the discharge of nitrogen trifluoride (NF₃) and oxygen (O₂).

The pressure value at which the plasma discharge is activated in the magnetron is 1.5 Torr. The process pressure is near-ambient and approximately equal to 700 Torr.

Consequently, forcing the gas stream, containing the oxygen (O) radicals at a low pressure, into a high-pressure reactor would pose a problem.

This problem is obviated by the provision of a pump 7 between the magnetron 8 and the chamber 2, which is definitely less expensive than the ozonizer of prior art apparatus.

The rotor pump 7 may be calibrated for operating in the 1 to 100 Torr range.

To prevent corrosion problems to the pump from the oxygen (O) radicals the pump may be kept lubricated with suitable lubricants, e.g. a polyfluorinated oil such as Fomblin.

The method and the reactor of this invention solves the technical problem of having as reactive gas the ozone in limited concentration, and offers a number of advantages, foremost among these being that they make possible a SACVD deposition with good gap-fill and step coverage feasible, and provide a significantly higher throughput than current systems.

## Claims

1. A method of applying a SACVD deposition technique for the fabrication of semiconductor integrated circuits, being of a type which comprises at least one step of depositing a layer of dielectric material, carried out inside a deposition reactor (1) which is fed by a stream of reaction gas, characterized by the use of a remote plasma of said reaction gas, and by an application of microwaves inside the gas feed conduit (3) of the reactor (1) to produce sufficient radicals of said gas to initiate the deposition reaction.

2. A method according to Claim 1, **characterized in that** said reaction gas is oxygen.

3. A method according to Claim 1, **characterized in that** the microwave activation pressure is 1.5 Torr.

4. A method according to Claim 1, **characterized in that** the stream of said remote plasma of the reaction gas is forced into the reactor (1).

5. A method according to Claim 1, **characterized in that** the reaction pressure is within the range of 1 to 700 Torr.

6. A deposition reactor (1) for implementing a SACVD deposition technique in the fabrication of semiconductor integrated circuits, of the type which comprises a reaction chamber (2) having a heater (5) associated therewith, and at least one reaction gas feed conduit (3) leading to the interior of said chamber, **characterized in that** it comprises a magnetron device (8) on said feed conduit (3) for producing, within said chamber (2), sufficient radicals of said gas to initiate the deposition reaction.

7. A reactor according to Claim 6, **characterized in that** it further comprises, on said conduit (3), a gas feed pump (7) for forcing said reaction gas feed into said chamber (2).

8. A reactor according to Claim 7, **characterized in that** said pump (7) is located downstream of said magnetron (8).
